# EUROPEAN PATENT APPLICATION

(11) **EP 4 756 875 A1**
(43) Date of publication of application: **10.06.2026**
(21) Application number: 25180624.6
(22) Date of filing: 04.06.2025
(51) Int. Cl.: H01L 23/525, H10D 84/08

(54) **ELECTRICAL FUSE HAVING FUSE LINK ALONG SIDEWALL(S) OF INACTIVE GATE STRUCTURE**

(30) Priority: 04.12.2024 US 202418968344
(71) Applicant: GlobalFoundries U.S. Inc., Malta, NY 12020 (US)
(72) Inventor: McCallum-Cook, Ian A., Essex Junction, VT 05452 (US); Cucci, Brett T., Essex Junction, VT 05452 (US); Gebreselasie, Ephrem, Essex Junction, VT 05452 (US)
(74) Representative: Grünecker Patent- und Rechtsanwälte PartG mbB

(57) **Abstract**

An electronic fuse includes an inactive gate structure over a substrate, and a fuse link along at least one sidewall of the inactive gate structure. A first terminal is at a first end of the fuse link, and a second terminal is at a second of the fuse link. The fuse link takes the form of a conductive metal spacer along at least one sidewall of the inactive gate structure and can be formed without a silicide process. Although the e-fuse can be used with any semiconductor device, it is advantageous for use with, for example, III-IV semiconductor devices. The method of making the e-fuse does not require any additional masks and provides a fuse link having a sub-photolithographic width dimension.

## Description

### STATEMENT REGARDING GOVERNMENT FUNDING

This application was made with government support under contract number HQ0727790700 awarded by the Defense Microelectronics Activity (DMEA). The US government has certain rights in the invention.

### BACKGROUND

The present disclosure relates to integrated circuits, and more specifically, to an electrical fuse having a fuse link along sidewall(s) of an inactive gate structure.

Different parts of an integrated circuit (IC) may be coupled using an electrical fuse (e-fuse). E-fuses can be 'programmed' to change interconnections within the IC. More particularly, metal within the fuse link can be caused to migrate by application of a prescribed current controlled by a transistor. Once sufficient metal has migrated, the fuse link is open or blown, stopping current from passing through the fuse. The e-fuse typically has a pair of terminals on the ends of the fuse link through which current is transmitted to program the e-fuse. The terminals typically include a silicon-metal alloy, i.e., silicide, to ensure good electrical connections, e.g., from contacts, to ends of the fuse link. III-V semiconductor devices, such as high electron mobility transistors (HEMTs) and metal-insulator-semiconductor HEMTs (MISHEMTs), have emerged as a leading technology for radio frequency (RF) and millimeter wave (mmWave) (e.g., 3-300GHz) wireless applications. The formation processes for a III-V semiconductor device does not use a silicide process because, among other reasons, the high temperature anneal required to form silicide can damage portions of the device. Hence, conventional silicided e-fuses are typically not usable with III-V semiconductor devices.

### SUMMARY

All aspects, examples and features mentioned below can be combined in any technically possible way.

An aspect of the disclosure provides an electronic fuse (e-fuse), comprising: an inactive gate structure over a substrate; a fuse link along at least one sidewall of the inactive gate structure; a first terminal at a first end of the fuse link; and a second terminal at a second of the fuse link.

An aspect of the disclosure provides an electronic fuse (e-fuse), comprising: an inactive gate structure over a substrate, the substrate including at least one layer including a III-V compound semiconductor, wherein the inactive gate structure includes a central body and a dielectric layer over the central body; a conductive metal spacer providing a fuse link along at least one sidewall of the inactive gate structure, wherein the dielectric layer is between the central body and the fuse link; a first terminal at a first end of the fuse link; and a second terminal at a second of the fuse link.

An aspect of the disclosure provides a method for forming an electronic fuse (e-fuse) device, comprising: forming a conductive metal layer over an inactive gate structure over a substrate; and forming a fuse link as a conductive metal spacer along at least one sidewall of the inactive gate structure and a terminal at each end of the fuse link from the conductive metal layer.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a top-down view of an electronic fuse (e-fuse), according to embodiments of the disclosure;
FIG. 2 shows a cross-sectional view along view line A-A in FIG. 1 of an e-fuse, according to embodiments of the disclosure;
FIG. 3 shows a cross-sectional view along view line B-B in FIG. 1 of an e-fuse, according to embodiments of the disclosure;
FIG. 4 shows a cross-sectional view of a step of a method of forming an e-fuse according to embodiments of the disclosure;
FIG. 5 shows a cross-sectional view of a step of a method of forming an e-fuse according to embodiments of the disclosure;
FIG. 6 shows a cross-sectional view of a step of a method of forming an e-fuse according to embodiments of the disclosure;
FIG. 7 shows a top-down view of a mask used to form a fuse link for an e-fuse according to embodiments of the disclosure;
FIG. 8 shows a top-down view of an e-fuse according to other embodiments of the disclosure;
FIG. 9 shows a cross-sectional view along view line C-C in FIG. 8 of a step of a method of forming the e-fuse according to other embodiments of the disclosure;
FIG. 10 shows a top-down view of an e-fuse according to additional embodiments of the disclosure; and
FIG. 11 shows a cross-sectional view of various steps of a method according to an alternative embodiment of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include an electronic fuse (hereafter "e-fuse"). The e-fuse includes an inactive gate structure over a substrate, and a fuse link along at least one sidewall of the inactive gate structure. A first terminal is at a first end of the fuse link, and a second terminal is at a second end of the fuse link. The fuse link takes the form of a conductive metal spacer along at least one sidewall of the inactive gate structure and can be formed without a silicide process. Although the e-fuse can be used with any semiconductor device, it is advantageous for use with, for example, III-V semiconductor devices. The method of making the e-fuse does not require any additional masks and provides a fuse link having a sub-photolithographic width dimension.

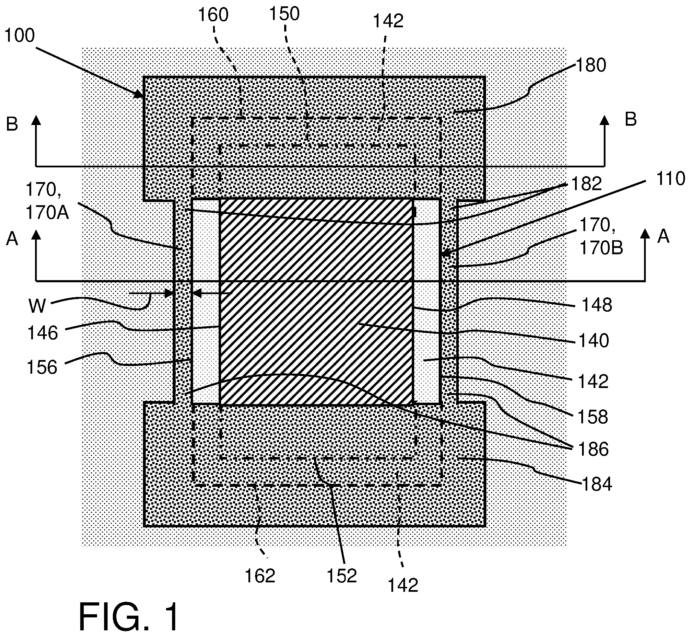

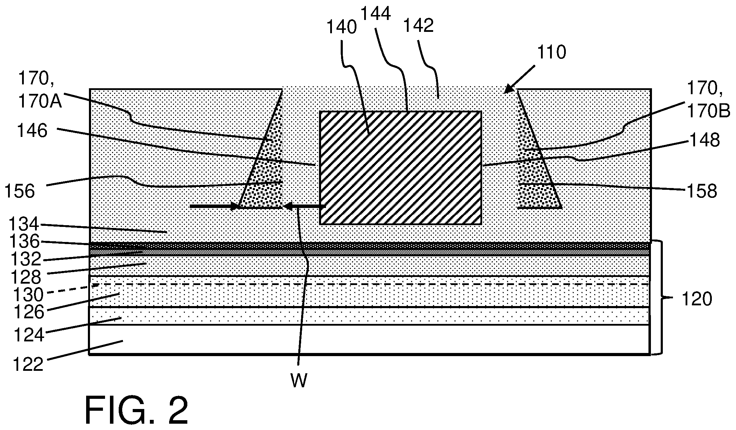

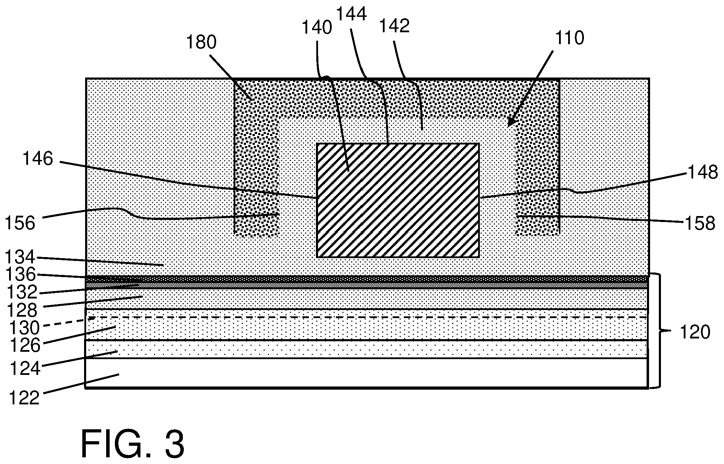

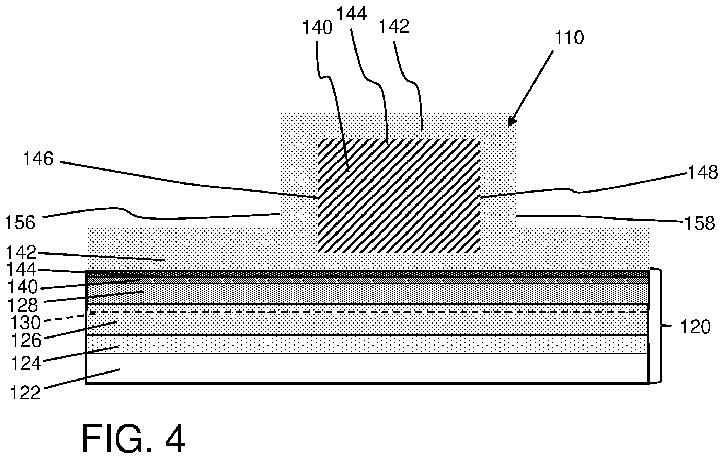

FIG. 1 shows a top-down view, FIG. 2 shows a cross-sectional view along view line A-A in FIG. 1, and FIG. 3 shows a cross-sectional view along view line B-B in FIG. 1, of an e-fuse 100, according to embodiments of the disclosure. E-fuse 100 includes an inactive gate structure 110 over a substrate 120. FIGS. 4-6 show various cross-sectional views of steps of a method of forming e-fuse 100, according to embodiments of the disclosure.

FIG. 4 shows a cross-sectional view along view line A-A in FIG. 1 subsequent to initial processing of a method according to embodiments of the disclosure. As shown in FIGS. 2-4, substrate 120 may include any now known or later developed semiconductor material(s) for a semiconductor device. A semiconductor material refers to a material whose conducting properties can be altered by doping with an impurity. Semiconductor materials include, for example, silicon-based semiconductor materials (e.g., silicon, silicon germanium, silicon germanium carbide, silicon carbide, etc.). Hence, in certain embodiments, substrate 120 may include at least one layer including silicon. Alternatively, substrate 120 may include a III-V compound semiconductor (i.e., compounds obtained by combining group III elements, such as aluminum, gallium, or indium, with group V elements, such as nitrogen, phosphorous, arsenic or antimony) (e.g., gallium nitride, indium phosphorous, gallium arsenic, or gallium phosphorous). Accordingly, in certain embodiments, substrate 120 includes at least one layer including a III-V compound semiconductor, e.g., gallium nitride. For purposes of the description, substrate 120 including III-V compound semiconductor material(s) will be described.

Referring to FIGS. 2-4, substrate 120 can include multiple epitaxially grown semiconductor layers. More particularly, substrate 120 includes a semiconductor base 122 that can be, for example, a silicon or silicon-based substrate (e.g., a silicon carbide (SiC) substrate), a sapphire substrate, a III-V semiconductor substrate (e.g., a gallium nitride (GaN) substrate or some other suitable III-V semiconductor substrate), a silicon substrate (perhaps doped p-type), or any other suitable substrate for a III-V semiconductor device. Epitaxially grown semiconductor layers of substrate 120 can include, for example: an optional buffer layer 124 on the top surface of semiconductor base 122; a channel layer 126 on buffer layer 124; and a barrier layer 128 on channel layer 126. These epitaxial grown semiconductor layers can be, for example, III-V semiconductor layers, as previously described.

Optional buffer layer 124 can be employed to facilitate growth of channel layer 126 and to provide for lattice constants of substrate 120 below and channel layer 126 above. Buffer layer 124 can be doped or undoped. Optionally, buffer layer 124 can be carbon-doped. Barrier layer 128 can have a band gap that is wider than the bandgap of channel layer 126 for the device channel. Where an active gate structure for a transistor is desired, those skilled in the art will recognize that the barrier and channel materials can be selected so that a heterojunction is formed at the interface between the two layers, thereby resulting in the formation of a two-dimensional electron gas (2DEG) region 130 in channel layer 126 (see dashed box). This 2DEG region 130 in channel layer 126 can provide the conductive pathway for the drifting of charges between a source region 150 and a drain region 152.

In some embodiments, buffer layer 124 could be a carbon-doped gallium nitride (C-GaN) buffer layer or a buffer layer of any other material suitable for use as a buffer layer of a high electron mobility transistors (HEMTs) and metal-insulator-semiconductor HEMTs (MISHEMTs). Channel layer 126 could be a gallium nitride (GaN) layer or a III-V semiconductor channel layer made of any other III-V semiconductor compound suitable for use as a channel layer in a HEMT or MISHEMT. Barrier layer 128 could be an aluminum gallium nitride (AlGaN) barrier layer or a barrier layer of any other material suitable for use as a barrier layer in a HEMT or MISHEMT. For purposes of illustration, the figures and the description depict the epitaxially grown layers (e.g., buffer layer 124; channel layer 126; and barrier layer 128) as being single layered structures (i.e., comprising one layer of buffer material, one layer of channel material and one layer of barrier material). However, it should be understood that, alternatively, any one or more of the epitaxially grown layers could be multi-layered structures (e.g., comprising multiple sub-layers of different buffer materials, multiple sub-layers of different III-V semiconductor channel materials and/or multiple sub-layers of different barrier materials).

One or more passivation layers may be over barrier layer 128. In the example shown, two passivation layers 132, 134 are shown with an etch stop layer 136 therebetween. Passivation layers 132, 134 may include one or more layers of any appropriate passivation material such as but not limited to aluminum oxide, silicon nitride and/or silicon oxide. For purposes of illustration, the figures and the description depict passivation layers 132, 134 as being single layered structures. However, it should be understood that, alternatively, one or both passivation layers 132, 134 could be multi-layered structures, e.g., comprising multiple sub-layers of different passivation materials. In certain embodiments, passivation layer 132 may include any interlevel or intra-level dielectric material including inorganic dielectric materials, organic dielectric materials, or combinations thereof. In this case, suitable passivation layer 132 materials may include but are not limited to: silicon oxide; silicon nitride; carbon-doped silicon dioxide materials; fluorinated silicate glass (FSG); organic polymeric thermoset materials; silicon oxycarbide; SiCOH dielectrics; fluorine doped silicon oxide; spin-on glasses; silsesquioxanes, including hydrogen silsesquioxane (HSQ), methyl silsesquioxane (MSQ) and mixtures or copolymers of HSQ and MSQ; benzocyclobutene (BCB)-based polymer dielectrics, and any silicon-containing low-k dielectric.

Etch stop layer 136 may be provided between passivation layers 132, 134 to protect the lower passivation layer 132 during etching processes. Etch stop layer 136 may include any now known or later developed etch stop material such as silicon nitride. Passivation layers 132, 134 and etch stop layer 136 may be formed using any now known or later developed deposition technique appropriate for the material deposited, e.g., chemical vapor deposition (CVD).

As shown in FIGS. 1-4, inactive gate structure 110 includes a central body 140 and a dielectric layer 142 thereover. Dielectric layer 142 is also on sidewalls 146, 148 and endwalls 150, 152 of central body 140. Central body 140 may include a variety of different materials depending on whether, for example, gate structures are formed in a gate-first or a replacement gate process. In a gate first process, central body 140 may include aluminum, titanium nitride or any other material typically used to form a gate structure for a III-V semiconductor device. In other examples, central body 140 may include amorphous silicon left as a dummy gate in a replacement gate process. In other examples, central body140 may include polysilicon, a metal (e.g., aluminum, tantalum, tungsten, etc.), or a gate conductor with a gate dielectric layer thereunder, e.g., where inactive gate structure 110 is formed along with active gate structures (not shown) for silicon-based semiconductor devices. In any event, inactive gate structure 110 does not include certain structure that would make it an active gate structure, i.e., capable of changing the conductivity of a channel region thereunder. For example, there are no contacts to central body 140 of inactive gate structure 110 for controlling electrical operation thereof. Further, as shown in FIGS. 2-4, for a III-V semiconductor device, central body 140 does not extend to channel layer 126, so it cannot create control a channel in 2DEG region 130. In other cases, central body 140 may not be conductive or the channel region thereunder may not be properly doped to form an active gate structure.

As shown in FIG. 4, central body 140 may be formed using any now known or later developed fabrication techniques. For example, in a gate first process, the material of central body 140 may be deposited by any appropriate deposition technique, e.g., atomic layer deposition for aluminum or aluminum nitride. A mask (not shown) may be patterned thereover and unwanted regions may be removed using any appropriate etch for the materials used, e.g., a reactive ion etch for aluminum or aluminum nitride, leaving central body 140 for inactive gate structure 110 (and perhaps central bodies for active gate structures elsewhere on the wafer). In another example, in a replacement metal gate (RMG) process, a sacrificial material is deposited, e.g., by chemical vapor deposition, and it is patterned to form sacrificial dummy gates. As understood by those with skill in the art, in a RMG process, other processing that could damage the final gate conductor(s) is then performed, e.g., doping of source/drain regions adjacent the inactive gate structures with high temperature anneal to drive in dopants. Once these other processes are carried out, the sacrificial dummy gates are subsequently replaced with the final gate conductor(s) to form active gate structures. With regard to inactive gate structure 110, the RMG process may be applied to create central body 140 with gate conductor(s) used in other active gate structures (not shown), or central body 140 may be left as is to include the sacrificial material, e.g., amorphous silicon or other sacrificial material typically used for dummy gates in a RMG process.

As shown by dashed lines in FIG. 1, dielectric layer 142 surrounds central body 140. More particularly, dielectric layer 142 extends along opposing sidewalls 146, 148 and opposing endwalls 150, 152 of central body 140. In FIG. 1, endwalls 150, 152 of central body 140 are shown under terminals 180, 184 of e-fuse 100. As shown in FIGS. 2-4, dielectric layer 142 extends over an upper surface 144 of central body 140. Inactive gate structure 110, as defined by dielectric layer 142, includes opposing sidewalls 156, 158 and opposing endwalls 160, 162.

Dielectric layer 142 can include any now known or later developed insulative material typically used to isolate central body 140, e.g., in a III-V semiconductor device. Suitable dielectric materials for dielectric layer 142 can include any now known or later developed interlevel dielectric such as but not limited to: silicon oxide; carbon-doped silicon dioxide materials; fluorinated silicate glass (FSG); organic polymeric thermoset materials; silicon oxycarbide; SiCOH dielectrics; fluorine doped silicon oxide; spin-on glasses; silsesquioxanes, including hydrogen silsesquioxane (HSQ), methyl silsesquioxane (MSQ) and mixtures or copolymers of HSQ and MSQ; benzocyclobutene (BCB)-based polymer dielectrics, and any silicon-containing low-k dielectric. In certain embodiments, dielectric layer 142 may include silicon oxide. As shown in FIG. 4, dielectric layer 142 can be formed using any appropriate deposition technique for the material used, e.g., CVD for silicon oxide.

As shown in FIGS. 1-3, e-fuse 100 also includes a fuse link 170 along at least one sidewall 156, 158 of inactive gate structure 110. More particularly, a conductive metal spacer provides fuse link 170 along sidewall(s) 156, 158 of inactive gate structure 110. Dielectric layer 142 is between fuse link 170 and central body 140. Fuse link 170 may be formed using any now known or later developed spacer formation technology. More particularly, a conductive metal can be deposited over inactive gate structure 110 and then etched back to create fuse link 170. Consequently, fuse link 170 has a maximum width W that is sub-photolithographic. While the dimensions that qualify as sub-photolithographic may vary depending on the photolithographic process used, in certain embodiments, maximum width W (FIG. 2) may be less than 120 nanometers. As shown in FIG. 2, maximum width W is typically at a lowermost portion of fuse link 170; however, it may be at other vertical locations along fuse link. 170. Fuse link 170 may have any common cross-sectional spacer shape. In the example shown, fuse link 170 has a triangular cross-sectional shape; however, a rectangular cross-sectional shape with a rounded outer corner is also possible.

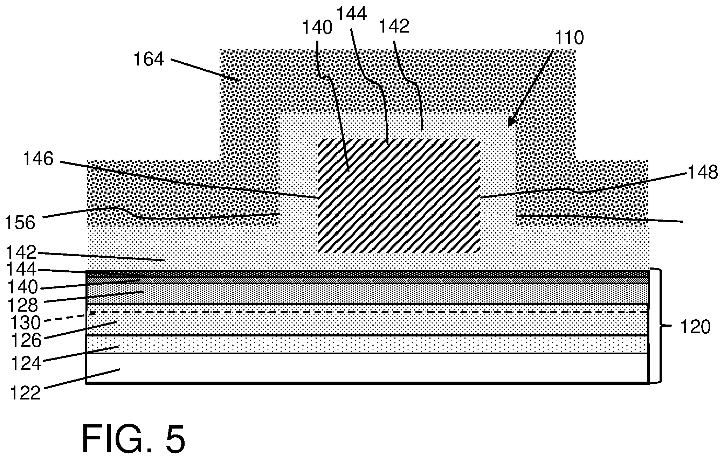

FIGS. 5-6 show cross-sectional views along view line A-A in FIG. 1 of forming fuse link 170. FIG. 5 shows forming a conductive metal layer 164 over inactive gate structure 110 over substrate 120. Conductive metal layer 164 may include any now known or later developed conductive metal. In certain embodiments, where III-V semiconductor devices are being formed, conductive metal layer 164 may include an ohmic metal typically used to form an active gate structure and source/drain contacts in a HEMT or MISHEMT. Ohmic metals may include but are not limited to aluminum, aluminum nitride, titanium nitride, titanium, tantalum nitride, tungsten or a combination of the metals listed. Conductive metal layer 164 may be formed, for example, by material deposition using any now known or later developed deposition technique appropriate for the conductive metal used, e.g., ALD of aluminum.

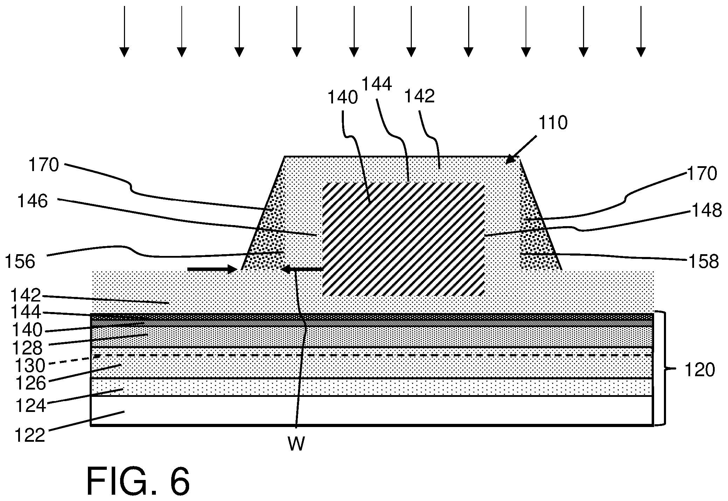

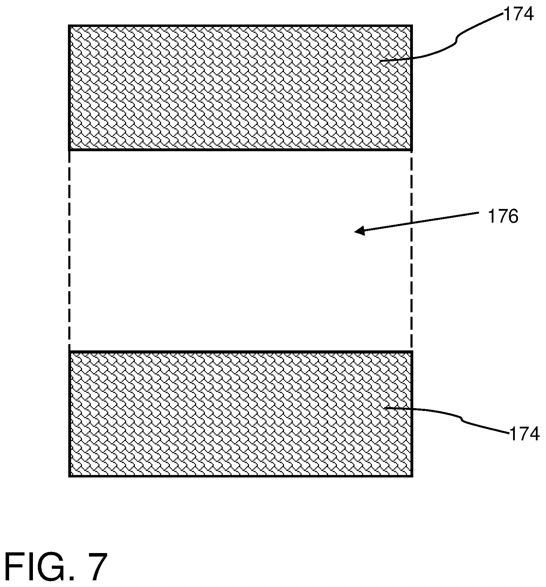

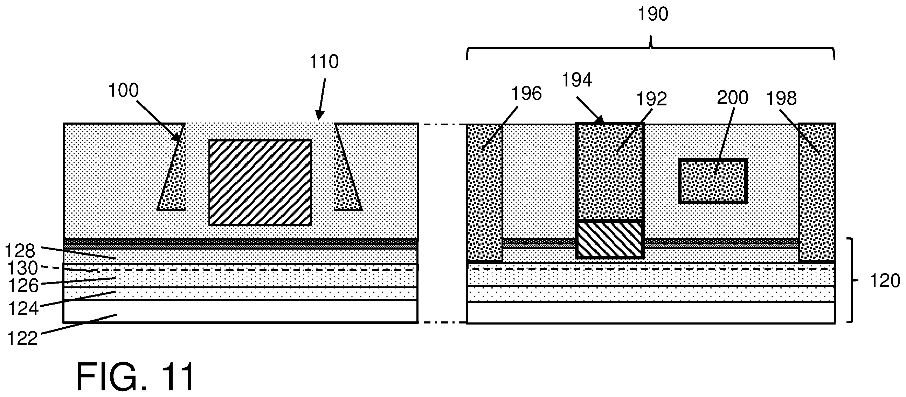

FIG. 6 shows forming fuse link 170 as a conductive metal spacer along at least one sidewall 156, 158 of inactive gate structure 110 and a terminal 180, 184 at each end 182, 186 of fuse link 170 from conductive metal layer 164. FIG. 7 shows a top-down view of a mask 174 used to form fuse link 170. Fuse link 170 can be formed by, as shown in FIG. 6, etching conductive metal layer 164 to form conductive metal spacer, i.e., fuse link 170, along at least one sidewall 156, 158 of inactive gate structure 110. The etching chemistry used in FIG. 6 may include any appropriate chemistry for conductive metal layer 164, e.g., a wet etch such as a reactive ion etch wet etch for ohmic metals, and removes conductive metal layer 164 from horizontal surfaces where exposed. Other etching chemistries may also be possible. As shown in FIG. 1, the forming of fuse link 170 may also include patterning conductive metal layer 164 to form a first terminal 180 at a first end 182 of fuse link 170, and a second terminal 184 at a second end 186 of fuse link 170. Here, forming fuse link 170 and terminal(s) 180, 184 includes patterning a mask 174 (FIG. 7) having an opening 176 exposing an area for fuse link 170 but not areas for first and second terminal(s) 180, 184 at each end 182, 186 of fuse link 170, and etching conductive metal layer 164. As understood in the field, mask 174 (FIG. 7) may be patterned to protect the locations of terminals 180, 184 while leaving conductive layer 164 to be etched where fuse link 170 is desired. More particularly, mask 174 would be formed over where conductive metal layer 164 is not to be removed and would have the same general shape as terminals 180, 184. With quick reference to FIG. 11, it will be recognized that mask 174 may also be used to pattern parts of active gate structures (see FIG. 11) in other parts of substrate 120, e.g., parts for a HEMT or MISHEMT 190 such as a central body 192 for an active gate structure 194 or source/drain regions 196, 198 therefor. After the etch, mask 174 would be removed, leaving fuse link 170 and first and second terminals 180, 184. Mask 174 may be removed using any known removal process appropriate for the mask material, e.g., a wet etch for hard nitride mask or an ashing process (oxygen dry strip process) for a soft resist-based mask. First and second terminals 180, 184 include the same material as fuse link 170.

In FIGS. 1-3, fuse link 170 is on both sidewalls 156, 158 of inactive gate structure 110. That is, there are two segments 170A, 170B of fuse link 170 with one on each sidewall 156 and 158 of inactive gate region 110 in the location of a spacer. More particularly, fuse link 170 includes a first fuse link (segment) 170A positioned along first sidewall 156 of inactive gate structure 110 in a location of a spacer and a second fuse link (segment) 170B positioned along a second, opposing sidewall 158 of inactive gate structure 110 in the location of the spacer.

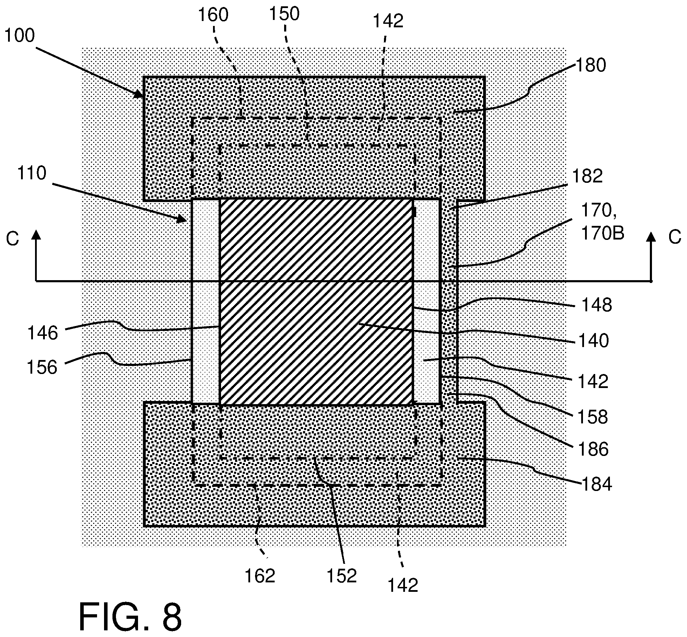

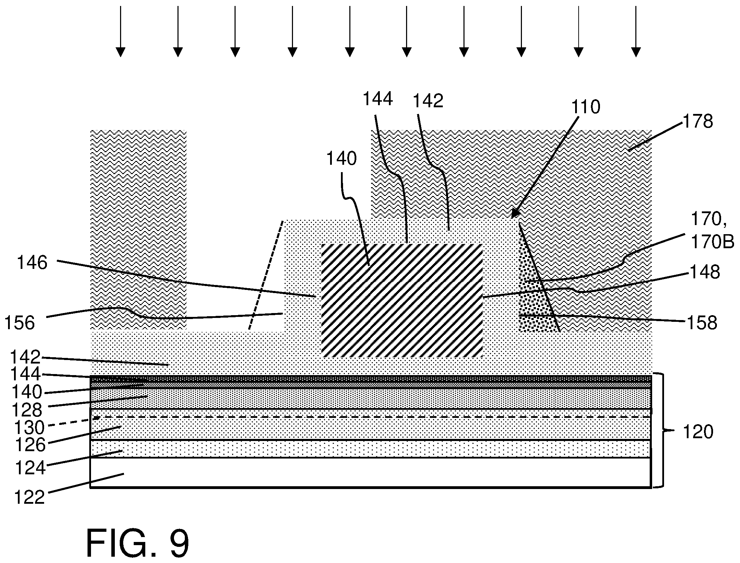

In certain embodiments, fuse link 170 may include a segment only on one of sidewalls 156, 158 of inactive gate structure 110. That is, fuse link 170 may be positioned along a single sidewall 156 or 158 of inactive gate structure 100 in a location of a spacer. FIG. 8 shows a top-down view and FIG. 9 shows a cross-sectional view along view line C-C in FIG. 8 with e-fuse 100 having fuse link 170 on only one of sidewalls (158 as shown) of inactive gate structure 110. In this alternative embodiment, as shown in FIG. 9, following the process in FIG. 6, a mask 178 may be formed and patterned to expose a selected sidewall 156 of inactive gate structure 110. An additional etching, shown in FIG. 9, removes the conductive metal spacer, i.e., fuse link 170, along sidewall 156, leaving fuse link (segment) 170B only on sidewall 158 of inactive gate structure 110. The etching chemistry used in FIG. 9 may include any appropriate chemistry for conductive metal layer 164. For example, the etch may include a chlorinated or fluorinated dry etch or a wet etch for ohmic metals. Other etching chemistries may also be possible. While FIG. 9 shows the segment of fuse link 170 along sidewall 156 removed, it will be recognized that fuse link 170 can be removed from any sidewall 156, 158 of inactive gate structure 110. As shown in FIG. 9, even though only a single fuse link segment 170B of fuse link 170 is used, E-fuse 100 still includes first terminal 180 at first end 182 of fuse link 170 segment 170B, and a second terminal 184 at a second end 186 of fuse link 170 segment 170B. Mask 178 may be removed using any known removal process appropriate for the mask material, e.g., a wet etch for hard nitride mask or an ashing process (oxygen dry strip process) for a soft resist-based mask.

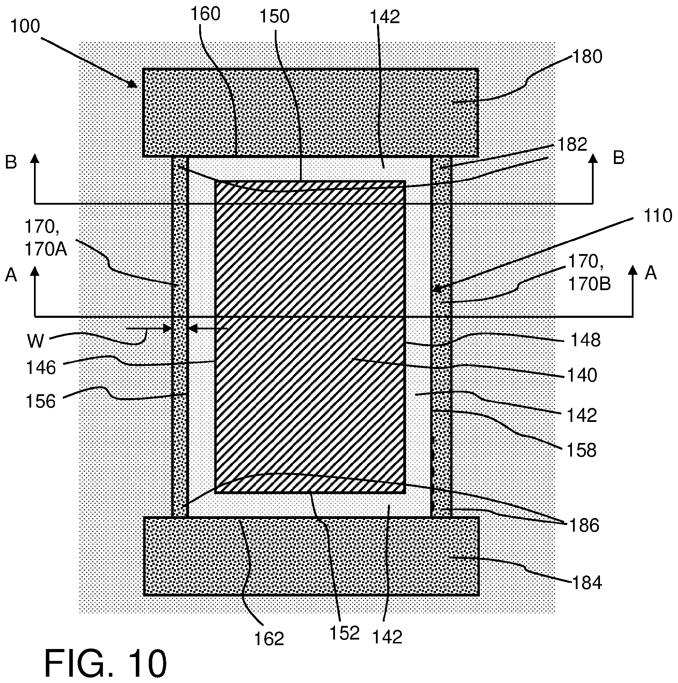

With further regard to terminals 180, 184, first terminal 180 and second terminal 184 may be electrically connected to fuse link 170 in a variety of ways. In certain embodiments, as shown in FIG. 1, at least one of first and second terminals 180, 184 is at least partially over inactive gate structure 110. That is, at least a part of terminal(s) 180, 184 is over central body 140 or dielectric layer 142 adjacent endwalls 150, 152 of central body 140. In this situation, terminals 180, 184 electrically connect to ends 182, 186 of at least one segment of fuse link 170 (both segments 170A, 170B in FIG. 1, or just segment 170B in FIG. 8). FIG. 10 shows a top-down view of e-fuse 100 according to other embodiments. In some embodiments, first terminal 180 and/or second terminal 184 may abut dielectric layer 142 as it extends around endwalls 160, 162 of inactive gate structure 110. It will be recognized that terminals 180, 184 so long as they electrically connect to fuse link 170 may be positioned in any location (vertically as arranged on the page for illustration purposes) between those illustrated in FIGS. 1 and 9 and may also move horizontally from that shown. In addition, the various versions illustrated and possible within the scope of the disclosure can be mixed and matched as desired on a given e-fuse 100, e.g., the arrangement of FIG. 1 can be used for one terminal and that of FIG. 10 can be used for another terminal.

FIG. 11 shows a cross-sectional view of various steps of a method according to an alternative embodiment of the disclosure. As shown in FIG. 11, a method according to embodiments of the disclosure may be incorporated with methods to form other structures for, for example, III-V semiconductor devices 190 in other locations of substrate 120. For example, as shown in FIG. 11, the method of forming fuse link 170 and terminals 180, 184 may also include forming, from conductive metal layer 164: a central body 192 of active gate structure 194 in contact with the at least one layer including gallium nitride (such as barrier layer 128 and/or channel layer 126), and a source region contact 196 and a drain region contact 198 adjacent active gate structure 194 (perhaps also in contact with layer(s) including gallium nitride). It will be recognized that the order of the steps used can be switched, e.g., contacts 196, 198 could be made before fuse link 170, and they may vary depending on how gate structures 110, 194 are formed, e.g., gate first (as shown) or RMG processing.

Embodiments of the disclosure provide various technical and commercial advantages, examples of which are discussed herein. For example, although the e-fuse can be used with any semiconductor device, it is advantageous for use with, for example, III-IV semiconductor devices. The method of making the e-fuse does not require any silicide process and does not require additional masks. The fuse link has a sub-photolithographic width dimension.

With further regard to the semiconductor materials described herein, a semiconductor material refers to a material whose conducting properties can be altered by doping with an impurity. A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region. Furthermore, when a semiconductor region or layer is described as being at a higher conductivity level than another semiconductor region or layer, it is more conductive (less resistive) than the other semiconductor region or layer; whereas, when a semiconductor region or layer is described as being at a lower conductivity level than another semiconductor region or layer, it is less conductive (more resistive) than that other semiconductor region or layer.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. **In** at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

**In** summary, an electronic fuse is provided, the electronic fuse including an inactive gate structure over a substrate, and a fuse link along at least one sidewall of the inactive gate structure. A first terminal is at a first end of the fuse link, and a second terminal is at a second of the fuse link. The fuse link takes the form of a conductive metal spacer along at least one sidewall of the inactive gate structure and can be formed without a silicide process. Although the e-fuse can be used with any semiconductor device, it is advantageous for use with, for example, III-IV semiconductor devices. The method of making the e-fuse does not require any additional masks and provides a fuse link having a sub-photolithographic width dimension.

The following embodiments are explicitly disclosed.
Embodiment 1: An electronic fuse (e-fuse), comprising:
   an inactive gate structure over a substrate;
   a fuse link along at least one sidewall of the inactive gate structure;
   a first terminal at a first end of the fuse link; and
   a second terminal at a second of the fuse link.
Embodiment 2: The e-fuse device of embodiment 1, wherein the fuse link has a maximum width of 120 nanometers.
Embodiment 3: The e-fuse device of embodiment 1 or 2, wherein the substrate includes at least one layer including a **III-V** compound semiconductor.
Embodiment 4: The e-fuse device of one of embodiments 1 to 3, wherein the substrate includes a silicon-based semiconductor material.
Embodiment 5: The e-fuse device of one of embodiments 1 to 4, wherein the fuse link is positioned along a single sidewall of the inactive gate structure in a location of a spacer.
Embodiment 6: The e-fuse device of one of embodiments 1 to 5, wherein the fuse link includes a first fuse link positioned along a first sidewall of the inactive gate structure and a second fuse link positioned along a second, opposing sidewall of the inactive gate structure.
   In some illustrative examples of embodiment 6, the fuse link may include the first fuse link positioned along the first sidewall of the inactive gate structure in a location of a spacer and may further include the second fuse link positioned along the second (opposing) sidewall of the inactive gate structure in the location of the spacer.
Embodiment 7: The e-fuse device of one of embodiments 1 to 6, wherein the inactive gate structure includes a central body and a dielectric layer between the fuse link and the central body.
Embodiment 8: The e-fuse device of embodiment 7, wherein the central body includes one of: amorphous silicon, polysilicon, a metal, and a gate conductor over a gate dielectric layer.
Embodiment 9: The e-fuse device of one of embodiments 1 to 8, wherein at least one of the first and second terminals is at least partially over the inactive gate structure.
Embodiment 10: The e-fuse device of one of embodiments 1 to 9, wherein the fuse link and the first and second terminals include at least one of: aluminum, aluminum nitride, titanium nitride, titanium, tantalum nitride, tungsten.
Embodiment 11: The e-fuse of one of embodiments 1 to 10, further comprising:
   a conductive metal spacer,
   wherein the inactive gate structure is located over the substrate, the substrate including at least one layer including a III-V compound semiconductor,
   wherein the inactive gate structure includes a central body and a dielectric layer over the central body,
   wherein the conductive metal spacer provides the fuse link along at least one sidewall of the inactive gate structure, and
   wherein the dielectric layer is between the central body and the fuse link.
Embodiment 12: An electronic fuse (e-fuse), comprising:
   an inactive gate structure over a substrate, the substrate including at least one layer including a III-V compound semiconductor, wherein the inactive gate structure includes a central body and a dielectric layer over the central body;
   a conductive metal spacer providing a fuse link along at least one sidewall of the inactive gate structure, wherein the dielectric layer is between the central body and the fuse link;
   a first terminal at a first end of the fuse link; and
   a second terminal at a second of the fuse link.
Embodiment 13: The e-fuse device of embodiment 11 or 12, wherein the fuse link has a maximum width of 120 nanometers.
Embodiment 14: The e-fuse device of one of embodiments 11 to 13, wherein the fuse link is positioned along a single sidewall of the inactive gate structure in a location of a spacer.
Embodiment 15: The e-fuse device of one of embodiments 11 to 14, wherein the fuse link includes a first fuse link positioned along a first sidewall of the inactive gate structure and a second fuse link positioned along a second, opposing sidewall of the inactive gate structure.
Embodiment 16: The e-fuse device of one of embodiments 11 to 15, wherein the central body includes one of: amorphous silicon, polysilicon, a metal, and a gate conductor over a gate dielectric layer.
Embodiment 17: The e-fuse device of one of embodiments 11 to 16, wherein at least one of the first and second terminals is at least partially over the inactive gate structure.
Embodiment 18: A method for forming an electronic fuse (e-fuse) device, comprising:
   forming a conductive metal layer over an inactive gate structure over a substrate; and
   forming a fuse link as a conductive metal spacer along at least one sidewall of the inactive gate structure and a terminal at each end of the fuse link from the conductive metal layer.
Embodiment 19: The method of embodiment 18, wherein forming the fuse link and the terminal includes patterning a mask having an opening exposing an area for the fuse link but not areas for the terminal at each end of the fuse link; and etching the conductive metal layer.
Embodiment 20: The method of embodiment 18 or 19, wherein the substrate includes at least one layer including a III-V compound semiconductor.
Embodiment 21: The method of embodiment 20, further comprising forming, from the conductive metal layer: a central body of an active gate structure in contact with the at least one layer including a III-V compound semiconductor, and a source region contact and a drain region contact adjacent the active gate structure.
Embodiment 22: The method of one of embodiments 18 to 21, wherein the e-fuse of one of embodiments 1 to 17 is formed.

## Claims

1. An electronic fuse (e-fuse), comprising:
an inactive gate structure over a substrate;
a fuse link along at least one sidewall of the inactive gate structure;
a first terminal at a first end of the fuse link; and
a second terminal at a second of the fuse link.

2. The e-fuse device of claim 1, wherein the fuse link has a maximum width of 120 nanometers.

3. The e-fuse device of claim 1 or 2, wherein the substrate includes at least one layer including a III-V compound semiconductor.

4. The e-fuse device of one of claims 1 to 3, wherein the substrate includes a silicon-based semiconductor material.

5. The e-fuse device of one of claims 1 to 4, wherein the fuse link is positioned along a single sidewall of the inactive gate structure in a location of a spacer.

6. The e-fuse device of one of claims 1 to 5, wherein the fuse link includes:
a first fuse link positioned along a first sidewall of the inactive gate structure, the first fuse link being preferably positioned in a location of a spacer, and
a second fuse link positioned along a second, opposing sidewall of the inactive gate structure, the second fuse link being preferably positioned in the location of the spacer.

7. The e-fuse device of one of claims 1 to 6, wherein the inactive gate structure includes a central body and a dielectric layer between the fuse link and the central body.

8. The e-fuse device of claim 7, wherein the central body includes one of: amorphous silicon, polysilicon, a metal, and a gate conductor over a gate dielectric layer.

9. The e-fuse device of one of claims 1 to 8, wherein at least one of the first and second terminals is at least partially over the inactive gate structure.

10. The e-fuse device of one of claims 1 to 9, wherein the fuse link and the first and second terminals include at least one of: aluminum, aluminum nitride, titanium nitride, titanium, tantalum nitride, tungsten.

11. The e-fuse of one of claims 1 to 10, further comprising:
a conductive metal spacer,
wherein the inactive gate structure is located over the substrate, the substrate including at least one layer including a III-V compound semiconductor,
wherein the inactive gate structure includes a central body and a dielectric layer over the central body,
wherein the conductive metal spacer provides the fuse link along at least one sidewall of the inactive gate structure, and
wherein the dielectric layer is between the central body and the fuse link.

12. A method for forming an electronic fuse (e-fuse) device, comprising:
forming a conductive metal layer over an inactive gate structure over a substrate; and
forming a fuse link as a conductive metal spacer along at least one sidewall of the inactive gate structure and a terminal at each end of the fuse link from the conductive metal layer.

13. The method of claim 12, wherein forming the fuse link and the terminal includes patterning a mask having an opening exposing an area for the fuse link but not areas for the terminal at each end of the fuse link; and etching the conductive metal layer.

14. The method of claim 12 or 13, wherein the substrate includes at least one layer including a III-V compound semiconductor.

15. The method of claim 14, further comprising forming, from the conductive metal layer: a central body of an active gate structure in contact with the at least one layer including a III-V compound semiconductor, and a source region contact and a drain region contact adjacent the active gate structure.
